# EUROPEAN PATENT SPECIFICATION

(11) **EP 4 313 908 B1**
(45) Date of publication and mention of the grant of the patent: **02.09.2026**
(21) Application number: 22714894.7
(22) Date of filing: 28.03.2022
(51) Int. Cl.: C04B 35/115, B28B 1/00, C04B 35/44, C04B 35/443, C04B 35/468, C04B 35/486, C04B 35/553, C04B 35/581, C04B 35/626, C04B 35/632, C04B 35/634, C04B 35/645

(54) **MATERIAL AND PROCESS FOR FABRICATING AND SHAPING OF TRANSPARENT CERAMICS**
MATERIAL UND VERFAHREN ZUR HERSTELLUNG UND FORMGEBUNG VON TRANSPARENTEN KERAMIKEN
MATÉRIAU ET PROCÉDÉ DE FABRICATION ET DE MISE EN FORME DE CÉRAMIQUES TRANSPARENTES

(30) Priority: 26.03.2021 EP 21165200
(43) Date of publication of application: 07.02.2024
(73) Proprietor: Glassomer GmbH, 79110 Freiburg (DE)
(72) Inventor: RAPP, Bastian, 79100 Freiburg (DE); KOTZ-HELMER, Frederik, 79232 March (DE)
(74) Representative: Müller-Boré & Partner Patentanwälte PartG mbB
(86) International application number: PCT/EP2022/058116
(87) International publication number: WO 2022/200629

(56) References cited:
- WO-A1-2020/120458
- WO-A1-2020/200424
- CN-A- 108 516 818
- CN-A- 109 650 853
- CN-A- 111 454 067
- CN-A- 111 499 371
- CN-A- 112 299 828
- KR-A- 20170 058 048
- US-A1- 2009 321 971
- US-A1- 2016 002 117
- US-B2- 7 927 538
- WANG HAOMIN ET AL: "3D Printing of Transparent Spinel Ceramics with Transmittance Approaching the Theoretical Limit", vol. 33, no. 15, 7 March 2021 (2021-03-07), DE, pages 2007072, XP055837029, ISSN: 0935-9648, Retrieved from the Internet <URL:https://onlinelibrary.wiley.com/doi/full-xml/10.1002/adma.202007072> DOI: 10.1002/adma.202007072
- GUANWEI LIU ET AL: "Fabrication of translucent alumina ceramics from pre-sintered bodies infiltrated with sintering additive precursor solutions", JOURNAL OF THE EUROPEAN CERAMIC SOCIETY, ELSEVIER SCIENCE PUBLISHERS, BARKING, ESSEX, GB, vol. 32, no. 4, 16 October 2011 (2011-10-16), pages 711 - 715, XP028345636, ISSN: 0955-2219, [retrieved on 20111020], DOI: 10.1016/J.JEURCERAMSOC.2011.10.019

## Description

The present invention relates to a moldable nanocomposite for producing a transparent article made of a ceramic material. Further, the present invention relates to a method of producing a transparent article made of a ceramic material.

Transparent ceramics like magnesium aluminate, also referred to as spinel, aluminum oxide, aluminum oxynitride, calcium fluoride, barium titanate, zirconia and yttrium aluminum garnet (YAG) are promising materials for the production of high-performance optics. Various processes are known in the art for fabricating and shaping of transparent ceramics, including hot pressing of particles and casting of water-based dispersions as the most important processes.

In hot pressing of particles, as described in G. Gilde et al., J. Am. Ceram. Soc. 2005, 88(10), 2747-2751, for instance, the particles are densified under high temperature and high pressure. Generally, hot pressing of particles requires flat surfaces by which the pressure can be applied. In casting of water-based dispersions, as described in A. Krell et al., J. Am. Ceram. Soc. 2003, 86(1), 12-18, for instance, the water-based dispersions are pre-densified into a powder in water, the water is evaporated, and the powder is sintered into a transparent ceramic. Generally, casting of water-based dispersions requires that the water can be removed through the pre-densified structure. As a result of the porosity induced by the water removal, inherent shrinkage and warping occur.

Haomin Wang et al., Adv. Mater. 2021, 33(15), 2007072 describes 3D printing of transparent spinel ceramics with transmittance approaching the theoretical limit.

WO 2020/120458 A1 describes a method for producing thin transparent ceramic parts, and thin transparent ceramic parts.

CN 109 650 853 A describes a preparation method of a transparent ceramic self-locking bracket.

CN 111 454 067 A describes a transparent ceramic orthodontic bracket and a preparation method thereof.

CN 112 299 828 A describes a preparation method of transparent ceramic backboard applied to a 5G solar mobile phone.

CN 111 499 371 A describes a preparation method of magnesium aluminate spinel transparent ceramics.

CN 108 516 818 A describes a method for preparing YAG transparent ceramics based on an improved Isobam gel system.

KR 2017 0058048 A describes a MgAl₂O₄ spinel forming method of MgAl₂O₄ spinel.

WO 2020/200424 A1 describes a sinterable feedstock for use in 3D printing devices.

US 7,927,538 B2 describes light-curing slips for the stereolithographic preparation of dental ceramics.

US 2016/002117 A1 describes a transparent spinel article and tape cast methods for making.

US 2009/321971 A1 describes methods of manufacturing dental restorations using nanocrystalline materials.

Guanwei Liu et al., J. Eur. Ceram. Soc. 2012, 32(4), 711-715 describes the fabrication of translucent alumina ceramics from pre-sintered bodies infiltrated with sintering additive precursor solutions.

Accordingly, in the above processes, there are severe limitations with respect to the shape of the transparent ceramics. That is, none of the above processes can yield a transparent article made of a ceramic material, wherein the transparent article may have any desired, i.e. any freely chosen geometric form.

**In** view of the above, it is an object of the present invention to overcome the drawbacks associated with the processes for fabricating and shaping of transparent ceramics known in the art. **In** particular, the technical problem underlying the present invention is to provide means for producing a transparent article made of a ceramic material which should allow the transparent article to be obtained having a freely chosen geometric form.

The above technical problem underlying the present invention has been solved by providing the embodiments characterized in the appended claims.

Specifically, in one aspect, the above technical problem has been solved by providing a moldable nanocomposite for producing a transparent article made of a ceramic material, the moldable nanocomposite according to the present invention comprising:
an organic binder;
a powder of the ceramic material dispersed in the organic binder, the powder comprising particles having a diameter in the range from 5 nm to 700 nm and, in addition thereto, comprising particles having a diameter in the range from 1 µm to 50 µm, and/or a precursor of the ceramic material dispersed in the organic binder, the precursor being at least one metal-containing compound; and
a phase-forming agent dispersed in the organic binder, the phase-forming agent being solid or having a viscosity of at least 5 mPa·s at 25 °C, as measured in accordance with DIN 53019, and forming an internal phase in the organic binder,
wherein the combined content of the powder and the precursor of the ceramic material in the moldable nanocomposite is at least 5 parts per volume based on 100 parts per volume of the organic binder,
wherein the content of the phase-forming agent in the moldable nanocomposite is at least 5 parts per volume based on 100 parts per volume of the organic binder,
wherein the moldable nanocomposite does not contain any solvent having a viscosity of less than 5 mPa·s at 25 °C, as measured in accordance with DIN 53019,
wherein the organic binder is a thermoplastic which can be hardened upon cooling or a resin which can be hardened upon curing or polymerizing initiated by an external stimulus, and
wherein the content of the organic binder with the powder and/or the precursor of the ceramic material dispersed therein, including any initiator added to the organic binder, amounts to at least 70 mass-%, with the total mass of the moldable nanocomposite being 100 mass-%.

Specifically, in another aspect, the above technical problem has been solved by providing a method of producing a transparent article made of a ceramic material, the method according to the present invention comprising the following steps (a) to (d):
(a) shaping the moldable nanocomposite according to the present invention into a predetermined geometric form before, during and/or after hardening of the organic binder, thereby obtaining a primary structure;
(b) debinding the primary structure obtained in step (a) by removing the organic binder, thereby obtaining a secondary structure, the secondary structure having cavities formed therein;
(c) optionally filling the cavities of the secondary structure obtained in step (b) with at least one additive; and
(d) sintering the secondary structure obtained in step (b) optionally filled with at least one additive in step (c), thereby obtaining the transparent article,
wherein the phase-forming agent is removed from the organic binder before or during debinding of the primary structure in step (b).

As found by the present inventors, due to the above-defined characteristics, the moldable nanocomposite according to the present invention which is used in the method according to the present invention can yield a transparent article made of a ceramic material having a freely chosen geometric form. The reason therefore lies in the organic binder having a powder and/or a precursor of the ceramic material dispersed therein. By hardening the organic binder, the moldable nanocomposite comprising the organic binder with the powder and/or the precursor of the ceramic material dispersed therein can be shaped into a predetermined geometric form, with the predetermined geometric form corresponding to the geometric form of the transparent article to be obtained.

Advantageously, as the moldable nanocomposite can be shaped into the predetermined geometric form by any suitable means known in the art, including subtractive manufacturing processes, additive manufacturing processes, replication processes, or combinations thereof, as described in more detail below, the predetermined geometric form is not further limited. Hence, the geometric form of the transparent article which is eventually obtained by debinding and sintering is not further limited, either. In other words, the geometric form of the transparent article which is made of the ceramic material originating from the powder and/or the precursor dispersed in the organic binder can be freely chosen. Due to the presence of a phase-forming agent dispersed in the organic binder, it is possible to effectively suppress the occurrence of cracks during the production of the transparent article. As a result, transparent articles having a comparatively large thickness can be realized by the method according to the present invention making use of the nanocomposite according to the present invention. Thus, according to the present invention, the "transparent article made of a ceramic material having a freely chosen geometric form" to be produced is understood as an article having any arbitrary form as long as the thickness of the same is typically more than 250 µm, preferably more than 600 µm, even more preferably at least 1.0 mm. It should be noted that the thickness of the transparent article refers to the shortest distance within the transparent article.

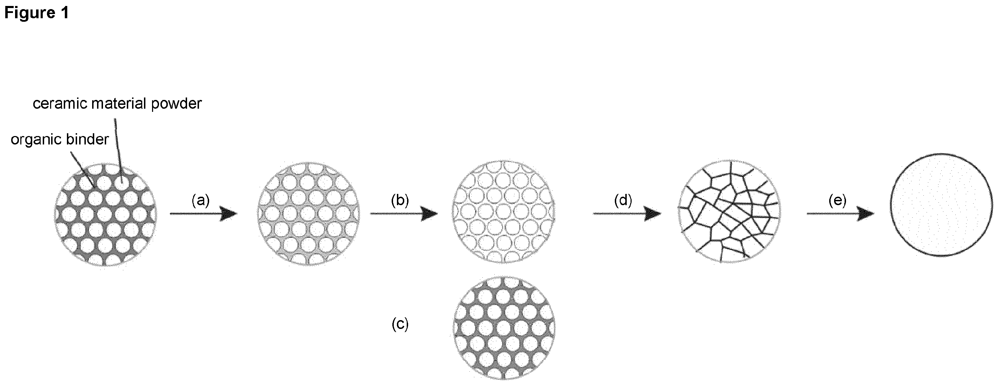

In the following, the moldable nanocomposite according to the present invention as well as the method according to the present invention are described in detail by reference to **Figure 1****,** the content of which is, however, not to be construed as limiting in any way.

According to the present invention, the nanocomposite for producing a transparent article made of a ceramic material is moldable, which means that the organic binder thereof is in or transferable to a moldable state. With the organic binder being in or transferable to a moldable state, the moldable nanocomposite can be shaped into a predetermined geometric form by hardening the organic binder, as described below in connection with the method according to the present invention.

Herein, the organic binder is a thermoplastic which can be hardened upon cooling or a resin which can be hardened upon curing or polymerizing initiated by an external stimulus. As such, the organic binder is in or transferable to a moldable state. As a result of hardening the organic binder, the primary structure obtained in step (a) maintains the predetermined geometric form into which the moldable nanocomposite has been shaped.

In one embodiment of the present invention, the organic binder is a thermoplastic which can be hardened upon cooling. Accordingly, cooling turns the softened thermoplastic into a solid so that the organic binder is no longer in a moldable state.

In case the organic binder is a thermoplastic, it may be selected from polyesters based on aromatic or aliphatic dicarboxylic acids and diols and/or hydroxycarboxylic acids, polycarbonates based on aliphatic or aromatic diols, polyolefins such as polyethylene, polypropylene, polybutene, polymethylpentene, polyisobutene, poly(ethylene-vinyl acetate), ethylene propylene rubber (EPR), poly(ethylene propylene diene), poly(vinyl butyral) (PVB), polyacrylates and polymethacrylates, cycloolefin polymers, as well as polyamides, polyacetals such as polyoxymethylene, polyethers such as polyethylene glycol (PEG), including aromatic polyethers based on bisphenols, or polyurethanes, or a combination thereof, without, however, being limited thereto.

In another embodiment of the present invention, the organic binder is a resin which can be hardened upon curing or polymerizing initiated by an external stimulus. In this context, as the external stimulus, heat or irradiation, in particular UV irradiation, may be mentioned. In some cases, mixing may be even sufficient as the external stimulus, e.g. in two-part resins, where the liquid constituents of the resin exhibit a sufficient reactivity towards each other. Further, as required, the external stimulus may include an initiator added to the organic binder for facilitating curing or polymerizing of the organic binder. Suitable initiators are known to the skilled person, such as acetophenones, e.g. 2,2-dimethoxy-2-phenylacetophenone (DMPAP), azo compounds, e.g. azobisisobutyronitrile (AIBN), benzophenone derivatives, fluorescein and its derivatives, e.g. rose bengal, quinones, e.g. camphorquinone, and phosphine derivatives, e.g. diphenyl(2,4,6-trimethylbenzoyl)phosphine oxide, without, however, being limited thereto. Accordingly, curing or polymerizing initiated by the external stimulus turns the liquid constituent(s) of the resin into a solid so that the organic binder is no longer in a moldable state. When exposed to the external stimulus, depending on the resin used, the resin is either cured which leads to a crosslinked structure or it is polymerized which leads to a non-crosslinked structure. In other words, the term "resin" as used herein not only encompasses thermosetting resins but also encompasses thermoplastic resins. That is, as the resin, any monomeric and/or oligomeric and/or polymeric composition may be mentioned herein without limitation.

In case the organic binder is a resin, it may be selected from acrylate resins and methacrylate resins, unsaturated polyester resins, vinyl ester resins, epoxy resins, thiol-ene resins, or polyurethane resins, without, however, being limited thereto. In particular, in case the organic binder is a resin, 2-hydroxyethyl methacrylate (HEMA) or a mixture of 2-hydroxyethyl methacrylate and tetraethylene glycol diacrylate (TEGDA) may be mentioned as the organic binder.

Apart from the organic binder, the moldable nanocomposite comprises a powder and/or a precursor of the ceramic material as an essential part. The powder and/or the precursor of the ceramic material are/is dispersed in the organic binder. Dispersion of the powder and/or the precursor of the ceramic material can be accomplished by any suitable means known in the art, depending on the organic binder used. In case a thermoplastic is used as the organic binder, the thermoplastic may be softened or it may be dissolved in a suitable organic solvent or gas phase before adding the powder and/or the precursor of the ceramic material thereto. In case a resin is used as the organic binder, the powder and/or the precursor of the ceramic material may be directly added to the liquid constituent(s) of the resin. Comprising both a powder of the ceramic material and a precursor of the ceramic material can lead to a higher filling level, which in turn can lead to a smaller shrinkage during sintering in step (d).

In case the moldable nanocomposite comprises a powder of the ceramic material, the powder comprises particles having a diameter in the range from 5 nm to 700 nm, preferably in the range from 7 nm to 400 nm, more preferably in the range from 20 nm to 350 nm, even more preferably in the range from 30 nm to 300 nm, and most preferably in the range from 50 nm to 250 nm. These particles are also referred to herein as the first type of particles. In addition thereto, the powder comprises particles having a diameter in the range from 1 µm to 50 µm, preferably in the range from 2 µm to 40 µm. These particles are also referred to herein as the second type of particles. As the powder comprises the first type of particles and the second type of particles, i.e. comprises a bimodal mixture of particles, the particles having the smaller diameter can fill the interstices between the particles having the larger diameter. Thereby, a denser packing of the particles in the moldable nanocomposite is achieved, which in turn leads to a smaller shrinkage during sintering in step (d). In principle, the powder may further comprise any other type of particles with a diameter different from that of the first type of particles and different from that of the second type of particles. Such multimodal mixtures of particles are also within the scope of the present invention.

Herein, the diameter of the first, second and any other type of particles is to be understood as the mean average diameter which is measured in accordance with ISO 9276-2. According to the present invention, the particles need not be (perfectly) spherical. That is, the particles may also be spheroidal, i.e. they may be sphere-like. For example, as regards the first type of particles with a diameter in the range from 5 nm to 700 nm, preferably in the range from 7 nm to 400 nm, more preferably in the range from 20 nm to 350 nm, even more preferably in the range from 30 nm to 300 nm, and most preferably in the range from 50 nm to 250 nm, this means that these particles may substantially have no dimension in which the diameter is smaller than 5 nm, preferably no dimension in which the diameter is smaller than 7 nm, more preferably no dimension in which the diameter is smaller than 20 nm, even more preferably no dimension in which the diameter is smaller than 30 nm, and most preferably no dimension in which the diameter is smaller than 50 nm, and substantially no dimension in which the diameter is larger than 700 nm, preferably no dimension in which the diameter is larger than 400 nm, more preferably no dimension in which the diameter is larger than 350 nm, even more preferably no dimension in which the diameter is larger than 300 nm, and most preferably no dimension in which the diameter is larger than 250 nm.

In case the moldable nanocomposite comprises a precursor of the ceramic material, the precursor is at least one metal-containing compound. Without limitation, the at least one metal-containing compound may be selected from the group consisting of organometallic compounds, metal complexes and metal salts, or may be a combination of two or more thereof. That is, the precursor of the ceramic material acts as the metal source for the ceramic material. In case the ceramic material contains only one metal, the precursor of the ceramic material is typically a single metal-containing compound. In case the ceramic material contains two or more metals, the precursor of the ceramic material is typically a mixture of two or more metal-containing compounds, wherein each metal-containing compound provides for one of the metals. Depending on the organic binder used, the precursor of the ceramic material may be dispersed therein in finely divided domains ranging from separated or complexed ions to ionic clusters as well as organometallic phases.

As mentioned above, the transparent article which is obtained from the moldable nanocomposite according to the present invention by the method according to the present invention is made of the ceramic material which originates from the powder and/or the precursor dispersed in the organic binder. According to the present invention, the ceramic material is not further limited. In particular, it may be selected depending on the intended use of the transparent article to be obtained. Without limitation, the ceramic material may be selected from the group consisting of magnesium aluminate, aluminum oxide, aluminum oxynitride, calcium fluoride, barium titanate, zirconia and yttrium aluminum garnet. In this context, the term "powder of the ceramic material", also referred to herein as ceramic material powder, means that the particles comprised in the powder are made of the ceramic material. Further, the term "precursor of the ceramic material", also referred to herein as ceramic material precursor, means that the ceramic material is formed from the at least one metal-containing compound during sintering in step (d).

According to the present invention, the combined content of the powder and the precursor of the ceramic material in the moldable nanocomposite is at least 5 parts per volume, preferably at least 30 parts per volume, more preferably at least 35 parts per volume based on 100 parts per volume of the organic binder. The higher the combined content of the powder and the precursor of the ceramic material with respect to the organic binder, the denser the packing of the ceramic material in the transparent article obtained in step (d). Surprisingly, even if the combined content of the powder and the precursor of the ceramic material with respect to the organic binder is rather high, e.g. 55 parts per volume based on 100 parts per volume of the organic binder or even more, it is still possible to shape the moldable nanocomposite into a predetermined geometric form in step (a).

Apart from the organic binder with the powder and/or the precursor of the ceramic material dispersed therein, the moldable nanocomposite comprises a phase-forming agent dispersed in the organic binder as an additional agent. The phase-forming agent facilitates debinding of the primary structure in step (b) so that the occurrence of cracks is effectively suppressed, as described in more detail below. The phase-forming agent, which is solid or has a viscosity of at least 5 mPa·s at room temperature, understood herein as 25 °C, forms an internal phase in the organic binder. Herein, the viscosity is measured in accordance with DIN 53019. The phase-forming agent is removed from the organic binder before or during debinding of the primary structure in step (b), e.g. by means of thermal treatment which leads to the evaporation or sublimation of the phase-forming agent, or which leads to its decomposition. Further, the phase-forming agent may be removed by means of solvent or gas phase extraction.

Examples of the phase-forming agent include alcohols, ethers and silicone oils as well as combinations thereof, with these substances having a sufficiently high molecular weight and/or having appropriate functionalization so as to be solid or have a viscosity of at least 5 mPa at room temperature. As a specific example, phenoxyethanol (POE) may be mentioned as the phase-forming agent. POE has a viscosity of about 30 mPa·s at room temperature, thus being a viscous substance. It can be evaporated at a temperature of 242 °C under atmospheric pressure. However, significant quantities thereof are already removed at lower temperatures due to its high vapor pressure. Further, PEG mentioned above may also act as the phase-forming agent.

Herein, the content of the phase-forming agent in the moldable nanocomposite is at least 5 parts per volume, preferably at least 10 parts per volume, more preferably at least 15 parts per volume based on 100 parts per volume of the organic binder. Thereby, it can be ensured that an internal phase is sufficiently formed in the organic binder so as to facilitate debinding of the primary structure in step (b) as described further below.

Apart from the phase-forming agent, the moldable nanocomposite may comprise one or more other additional agents, as required, which facilitate the production of the transparent article to be obtained. According to the present invention, the content of any additional agents taken as a whole in the moldable nanocomposite does not amount to more than 30 mass-%, preferably not more than 15 mass-%, more preferably not more than 10 mass-%, even more preferably not more than 5 mass-%, with the total mass of the moldable nanocomposite being 100 mass-%. That is, the moldable nanocomposite according to the present invention essentially consists of the organic binder with the powder and/or the precursor of the ceramic material dispersed therein, including any initiator added to the organic binder. Herein, the term "essentially consists of" means that the content of the organic binder with the powder and/or the precursor of the ceramic material dispersed therein, including any initiator added to the organic binder, amounts to at least 70 mass-%, preferably at least 85 mass-%, more preferably at least 90 mass-%, even more preferably at least 95 mass-%, with the total mass of the moldable nanocomposite being 100 mass-% (the remainder consisting of the phase-forming agent and optional other additional agents).

For example, in order to facilitate dispersion of the powder and/or the precursor of the ceramic material in the organic binder, a dispersion agent may be present. As the dispersion agent, nonionic surfactants, e.g. polyoxyethylene alkyl ether or polyoxymethylene, and anionic surfactants, e.g. fatty acids and their salts or aliphatic carboxylic acids and their salts, such as stearic acid and its salts or oleic acid and its salts, may be mentioned without limitation. Another example of a dispersion agent suitably used in the present invention is 2-[2-(2-methoxyethoxy)ethoxy]acetic acid which may also act as the phase-forming agent. According to the present invention, it is not necessary that a dispersion agent is present. That is, the present invention also encompasses embodiments, where the moldable nanocomposite does not contain any dispersion agent.

Notably, once the primary structure has been formed, the organic binder is in a solid state (not a liquid, gel, or paste-like state). As known to the skilled person, a solid is characterized in that it is not possible to determine a viscosity thereof. Typically, the moldable nanocomposite does not contain any thickening agent. Herein, the moldable nanocomposite does not contain any solvent having a viscosity of less than 5 mPa·s at room temperature, as measured in accordance with DIN 53019, like water. According to a specific embodiment of the present invention, the moldable nanocomposite neither contains triglycerides, waxes, and paraffin nor contains any plasticizer such as phthalates and any derivatives thereof.

In step (a) of the method according to the present invention, the moldable nanocomposite according to the present invention, which has been described above in detail, is shaped into a predetermined geometric form before, during and/or after hardening of the organic binder. Thereby, a primary structure, also referred to as green body, is obtained. Depending on the organic binder used, hardening is either accomplished upon cooling or upon curing or polymerizing initiated by an external stimulus. The shape of the primary structure already reflects the shape of the transparent article obtained in step (d).

Shaping of the moldable nanocomposite into the predetermined geometric form can be accomplished by any suitable means known in the art. In particular, the moldable nanocomposite may be shaped in step (a) by means of a subtractive manufacturing process, an additive manufacturing process, a replication process, or a combination thereof. Depending on the process(es) applied, the organic binder with the powder and/or the precursor of the ceramic material dispersed therein is hardened before, during and/or after shaping of the moldable nanocomposite.

In case of subtractive manufacturing processes, the organic binder with the powder and/or the precursor of the ceramic material dispersed therein is hardened before shaping of the moldable nanocomposite. In other words, the moldable nanocomposite is shaped into the predetermined geometric form after hardening of the organic binder. Suitable subtractive manufacturing processes include but are not limited to laser-based structuring techniques as well as CNC machining techniques such as milling, drilling, grinding, sawing, lathing, and polishing.

In case of additive manufacturing processes, the organic binder with the powder and/or the precursor of the ceramic material dispersed therein is hardened during shaping of the moldable nanocomposite. In other words, the moldable nanocomposite is shaped into the predetermined geometric form during hardening of the organic binder. Suitable additive manufacturing processes include but are not limited to selective laser sintering and selective laser melting, fused filament fabrication, also referred to as fused deposition modeling, stereolithography, two-photon polymerization, inkjet printing as well as volumetric printing techniques.

In case of replication processes, the organic binder with the powder and/or the precursor of the ceramic material dispersed therein is hardened after shaping of the moldable nanocomposite. In other words, the moldable nanocomposite is shaped into the predetermined geometric form before hardening of the organic binder. Suitable replication processes include but are not limited to casting, injection molding, (injection) compression molding, extrusion, thermoforming, cold or hot drawing, hot embossing, nanoim-printing as well as blow molding.

As already mentioned above, in order to shape the moldable nanocomposite into the predetermined geometric form, one or more subtractive manufacturing processes, additive manufacturing processes, and replication processes may be combined. For example, when the moldable nanocomposite is shaped by means of a replication process and the primary structure has visible artefacts resulting from said replication process, a subtractive manufacturing process may be applied to the primary structure as post-processing. Alternatively, coating techniques may be applied as post-processing in order to smoothen the surface of the primary structure obtained in step (a).

In step (b) of the method according to the present invention, the primary structure obtained in step (a) is debound by removing the organic binder. Thereby, a secondary structure, also referred to as brown body, is obtained. As a result of debinding the primary structure, i.e. removing the organic binder, the obtained secondary structure has cavities formed therein.

Depending on the organic binder used, the primary structure obtained in step (a) may be debound in step (b) by means of thermal treatment, chemical reaction, reduced pressure, solvent or gas phase extraction, or a combination thereof. For example, the primary structure may be first immersed in a solvent for carrying out solvent extraction before being thermally treated. In principle, any means may be applied which can remove the organic binder without adversely affecting the powder and/or the precursor of the ceramic material forming the secondary structure. In this context, a person skilled in the art routinely selects appropriate conditions to be applied for removing the organic binder in step (b).

For example, in case debinding is accomplished by means of thermal treatment, the temperature applied during debinding is typically in the range from 100 °C to 600 °C, e.g. in the range from 150 °C to 550 °C, the heating rate is typically in the range from 0.1 °C/min to 5 °C/min, e.g. in the range from 0.5 °C/min to 1 °C/min, and the holding time is typically in the range from 2 minutes to 12 hours, depending on the size of the transparent article to be obtained. In case the size thereof is rather small, already a few seconds may be sufficient for debinding the primary structure in step (b). Thermal treatment may also be carried out in a stepwise manner. In accordance with the above considerations, debinding by means of thermal treatment can be further facilitated by means of reduced pressure, i.e. sub-atmospheric pressure, which renders the organic binder more volatile.

In case the moldable nanocomposite comprises a powder of the ceramic material, the particles comprised in the powder adhere together due to hydrogen bonds after removal of the organic binder. Thereby, mechanical stability is imparted to the secondary structure. Taking account of the size of the particles, the diameter of which lies in the nanometer range, the particles have a high specific surface area which allows for sufficient interaction to keep the secondary structure mechanically stable. In case the moldable nanocomposite comprises a precursor of the ceramic material, the secondary structure is stabilized by the inherent cohesive forces of the at least one metal-containing compound as well as by its interaction with the particles comprised in the powder of the ceramic material, if present. As an example, an organometallic compound may interact via secondary forces such as hydrophobic interaction, van-der-Waals forces, and hydrogen bonding, while metal salts form electrostatic interactions which stabilize the secondary structure. Generally, the secondary structure obtained in step (b) has an amorphous or semicrystalline morphology.

Before the organic binder is removed in step (b), or during the removal of the organic binder, the phase-forming agent is removed from the primary structure, e.g. by evaporation or sublimation, or by decomposition. Removal of the phase-forming agent can also be accomplished by means of solvent or gas phase extraction. In principle, the same means may be applied as described above in connection with the removal of the organic binder.

As a result of removing the phase-forming agent, debinding of the primary structure in step (b) is facilitated. The reason therefore is that the internal phase formed by the phase-forming agent in the organic binder generates pores in the primary structure when it is removed. Through these pores, the organic binder that remains can then be removed in a more controlled manner. Thereby, the secondary structure is more easily prevented from being damaged, in particular when it adopts a thick structure. The same applies when the organic binder is removed in several steps. For example, in case the organic binder is a combination of two or more binder components exhibiting different thermal decomposition behavior, debinding may be accomplished sequentially. In this case, after having removed the first binder component, i.e. the binder component with the lowest decomposition temperature, the removal of the further binder component(s) is facilitated due to the pores generated in the primary structure after removal of the first binder component.

Debinding of the primary structure in step (b) also allows the removal of an immersed template structure that acts as a lost form within the primary structure. Once the immersed template structure which is solely composed of a material identical or chemically similar to the organic binder has been removed during debinding of the primary structure, the inverse thereof is left as a hollow structure within the obtained secondary structure. This modification is also referred to as sacrificial template replication.

In step (c) of the method according to the present invention, the cavities of the secondary structure obtained in step (b) may be filled with at least one additive. According to the present invention, step (c) is optional. The at least one additive, also referred to as filler, necessarily has a suitable size so that it can be introduced into the cavities formed in the secondary structure. Herein, the at least one additive is not further limited and may be selected as appropriate.

For example, in order to impart a specific color to the transparent article to be obtained, the at least one additive may be selected from pigments such as gold(III) chloride (AuCl₃), vanadium(III) chloride (VCl₃) and chromium(III) nitrate (Cr(NO₃)₃), for instance. Since the secondary structure is exposed to rather high temperatures when sintered in step (d) as described further below, the pigments need to withstand these temperatures. Therefore, inorganic pigments like those mentioned above are preferred compared to organic pigments which may be prone to decomposition when heated to the rather high temperatures applied during sintering.

Generally, in order to impart specific optical characteristics to the transparent article to be obtained, the at least one additive may also be selected from doping reagents which, upon decomposition during sintering in step (d), lead to a dopant such as Ag, Al, Au, B, Ti, F, Fe, Na, Ni, K, Ca, Cr, Ce, Co, Cu, Dy, Er, Eu, Gd, Ho, La, Lu, Nd, P, Pt, Pr, Pm, Rh, Sm, Sc, Tb, Tm, V, Yb, Y, Ge, Pb, Ba, Zr, Zn, and Mg, for instance. Suitable doping reagents are known to the skilled person.

Moreover, in order to increase the density of the transparent article to be obtained, the at least one additive may also be selected from a powder of the ceramic material and a precursor of the ceramic material. By filling the secondary structure with the powder and/or the precursor of the ceramic material, shrinkage of the secondary structure during sintering can be reduced. Accordingly, after sintering in step (d), the ceramic material not only originates from the powder and/or the precursor dispersed in the organic binder, but also originates from the powder and/or the precursor used as the at least one additive. In this context, the considerations as outlined above for the powder and/or the precursor of the ceramic material dispersed in the organic binder are equally applicable to the powder and/or the precursor of the ceramic material used as the at least one additive. As it is clear to the skilled person, in case a powder of the ceramic material is used as the at least one additive, the particles comprised in the powder need to have a suitable diameter, i.e. a suitable size, further to what has been outlined above.

The cavities of the secondary structure may be filled with the at least one additive in step (c) by immersing the secondary structure in a solution containing the at least one additive, exposing the secondary structure to physical or chemical vapor deposition in an atmosphere containing or generating the at least one additive, or a combination thereof. However, in principle, any other filling process may be applied in this respect as well. For example, it is also possible to apply a sol-gel process. Depending on the at least one additive with which the cavities of the secondary structure are filled in step (c), the secondary structure may be first immersed in a solution containing one of the additives, and may then be exposed to physical or chemical vapor deposition containing or generating another one of the additives. As appropriate, the cavities of the secondary structure may be filled with the at least one additive even before debinding of the primary structure is completed. In this case, it is the partially debound primary structure which is filled with the at least one additive.

In step (d) of the method according to the present invention, the secondary structure obtained in step (b) optionally filled with at least one additive in step (c) is sintered. Thereby, the transparent article is obtained.

Suitable sintering conditions are known to the skilled person and are routinely selected as appropriate. Without limitation, the temperature applied during sintering is typically in the range from 700 °C to 2000 °C, the heating rate is typically in the range from 1 °C/min to 10 °C/min, e.g. 5 °C/min, and the holding time is typically in the range from 0.5 hours to 48 hours, e.g. 4 hours, depending on the size of the transparent article to be obtained.

In case the moldable nanocomposite comprises a precursor of the ceramic material dispersed in the organic binder, and/or in case a precursor of the ceramic material is used as the at least one additive, the secondary structure may be pre-sintered before step (d) at an intermediate temperature in order to convert the precursor of the ceramic material into the ceramic material. For example, pre-sintering may be carried out at a temperature in the range from 400 °C to 700 °C.

After step (d), the obtained transparent article, the density of which is typically at least 90% of the theoretical density, can be cooled to room temperature and used as obtained. Herein, an article is to be understood as transparent when exhibiting an optical transmission of more than 10%, preferably more than 30%, and even more preferably more than 50% at a wavelength in the range from 400 nm to 1000 nm for a thickness of 1.0 mm. In order to achieve full densification, step (d) may include subjecting the sintered secondary structure to hot isostatic pressing (HIP). That is, when subjecting the sintered secondary structure to hot isostatic pressing, the obtained transparent article has a density of approximately 100% of the theoretical density.

Hot isostatic pressing involves the application of high temperature and high pressure in an inert gas atmosphere, e.g. in an argon atmosphere. Without limitation, the temperature applied during hot isostatic pressing is typically in the range from 1000 °C to 1800 °C, the heating rate is typically in the range from 1 °C/min to 5 °C/min, e.g. 3 °C/min, and the holding time is typically in the range from 0.5 hours to 4 hours, e.g. 2 hours, depending on the size of the transparent article obtained. The pressure applied during hot isostatic pressing is typically in the range from 100 MPa to 300 MPa, e.g. 150 MPa, without, however, being limited thereto. As a result of hot isostatic pressing, there are hardly any pores remaining within the bulk of the obtained transparent article.

As already mentioned above, the secondary structure obtained in step (b) has an amorphous or semicrystalline morphology. The same applies to the transparent article obtained in step (d). Therefore, as required, the secondary structure obtained in step (b) or the transparent article obtained in step (d) may be transformed into a single crystal. For doing so, either the secondary structure obtained in step (b) or the transparent article obtained in step (d) is exposed to an external stimulus, e.g. heat or irradiation. The transformation is induced via abnormal grain growth with a seed crystal. Without limitation, to accomplish single crystal transformation via abnormal grain growth, the following protocol may be applied in a hydrogen atmosphere after seeding the secondary structure obtained in step (b) or the transparent article obtained in step (d):

| | | | |
|---|---|---|---|
| • | heating rate: 15 °C/minute: | 25 °C → 1880 °C | holding time: 3 hours |
| • | cooling rate: 15 °C/minute: | 1880 °C → 1750 °C | holding time: 100 hours |
| • | cooling rate: 15 °C/minute: | 1750 °C → 25 °C | end |

In case the above protocol is carried out after step (b), a holding step at 1300 °C, for instance, may be additionally employed beforehand.

Single crystal transformation via abnormal grain growth is well established in the art. Details thereof can be found in US 5,549,746, C. Scott et al., J. Am. Ceram. Soc. 2002, 85(5), 1275-1280, and S. Dillon et al., J. Am. Ceram. Soc. 2007, 90(3), 993-995, for instance.

Herein, the transformation of the secondary structure obtained in step (b) or the transparent article obtained in step (d) into a single crystal is also referred to as step (e). According to the present invention, step (e) is optional.

The transparent article which is obtained from the moldable nanocomposite according to the present invention by the method according to the present invention is suitable for a variety of different applications, among others, applications in the field of optics, e.g. as a lens, taking into account that the geometric form thereof can be freely chosen. Advantageously, with the present invention, it is even possible to realize transparent articles having a comparatively large thickness. Since any suitable means known in the art, including subtractive manufacturing processes, additive manufacturing processes, replication processes, or combinations thereof, may be applied herein, the method according to the present invention making use of the nanocomposite according to the present invention allows the production of the transparent article made of a ceramic material with both high throughput and high resolution.

### The Figures show:

**Figure 1** shows the exemplary production of a transparent article made of a ceramic material in accordance with the present invention by making reference to steps (a) to (e): (a) a primary structure is obtained from a moldable nanocomposite comprising an organic binder and a powder of the ceramic material dispersed therein; (b) a secondary structure is obtained from the primary structure, and (c) filled with at least one additive; (d) a transparent article is obtained from the secondary structure; and (e) a single crystal is obtained from the transparent article. Steps (c) and (e) are optional. Instead of using a ceramic material powder, or in addition thereto, it is possible to use a ceramic material precursor. Further, it is possible to carry out step (e) directly after step (b).
**Figure 2** shows the UV/Vis spectrum of the transparent article made of spinel as obtained after hot isostatic pressing in Example 1 described further below.
**Figure 3** shows a photograph of the transparent article made of spinel as obtained after hot isostatic pressing in Example 2 described further below.
**Figure 4** shows a photograph of the transparent article made of spinel as obtained after hot isostatic pressing in Example 3 described further below.
**Figure 5** shows a photograph of the broken article made of spinel as obtained after sintering in the Comparative Example described further below.

### Examples

The present disclosure is further illustrated by the following Examples without, however, being limited thereto.

### Example 1 (Reference Example)

Production of a transparent article made of spinel by means of casting

A moldable nanocomposite was obtained by dispersing 38 parts per volume of spinel nanopowder having a mean average diameter of 200 nm in 100 parts per volume of a mixture of 2-hydroxyethyl methacrylate (68 parts per volume) and tetraethylene glycol diacrylate (7 parts per volume) as the organic binder, and 2-[2-(2-methoxyethoxy)ethoxy]acetic acid (25 parts per volume) as the dispersion agent, which also acted as the phase-forming agent. 2,2-Dimethoxy-2-phenylacetophenone was added as the initiator for facilitating photocuring of the organic binder.

The moldable nanocomposite was cast into a polyethylene mold and the organic binder was hardened upon curing with light having a wavelength in the range from 300 nm to 400 nm, thereby obtaining a green body. The organic binder was removed from the obtained green body by thermal debinding applying the following protocol, thereby obtaining a brown body:

| | | | |
|---|---|---|---|
| • | heating rate: 0.5 °C/minute: | 25 °C → 150 °C | holding time: 4 hours |
| • | heating rate: 0.5 °C/minute: | 150 °C → 280 °C | holding time: 4 hours |
| • | heating rate: 1 °C/minute: | 280 °C → 550 °C | holding time: 2 hours |
| • | cooling rate: 5 °C/minute: | 550 °C → 25 °C | end |

The obtained brown body was sintered to reach a density of about 96% to 100% of the theoretical density applying the following protocol:

| | | | |
|---|---|---|---|
| • | heating rate: 5 °C/minute: | 25 °C → 1530 °C | holding time: 4 hours |
| • | cooling rate: 5 °C/minute: | 1530 °C → 25 °C | end |

Full densification was accomplished by means of hot isostatic pressing under a pressure of 150 MPa in an argon atmosphere applying the following protocol:

| | | | |
|---|---|---|---|
| • | heating rate: 3 °C/minute: | 25 °C → 1700 °C | holding time: 2 hours |
| • | cooling rate: 3 °C/minute: | 1700 °C → 25 °C | end |

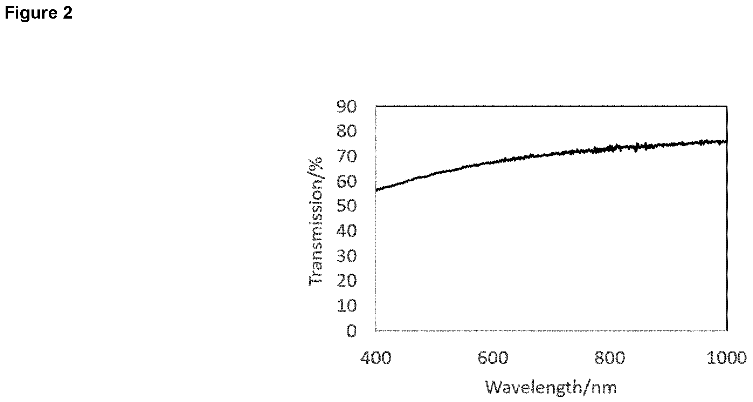

After hot isostatic pressing, a transparent article made of spinel was obtained, which had a polycrystalline morphology and exhibited an optical transmission of more than 50% at a wavelength in the range from 400 nm to 1000 nm for a thickness of 1.0 mm, as can be seen from **Figure 2****.**

### Example 2 (Reference Example)

Production of a transparent article made of spinel by means of stereolithography
A moldable nanocomposite was obtained by dispersing 38 parts per volume of spinel nanopowder having a mean average diameter of 200 nm in 100 parts per volume of a mixture of 2-hydroxyethyl methacrylate (68 parts per volume) and tetraethylene glycol diacrylate (7 parts per volume) as the organic binder, and 2-[2-(2-methoxyethoxy)ethoxy]acetic acid (25 parts per volume) as the dispersion agent, which also acted as the phase-forming agent. 2,2-Dimethoxy-2-phenylacetophenone was added as the initiator for facilitating photocuring of the organic binder.

The moldable nanocomposite was printed using a conventional 3D printer (Asiga Pico 2 stereolithography system). During printing, the organic binder was hardened upon curing with light having a wavelength in the range from 300 nm to 400 nm as provided by a light source integrated in the printer, thereby obtaining a green body.

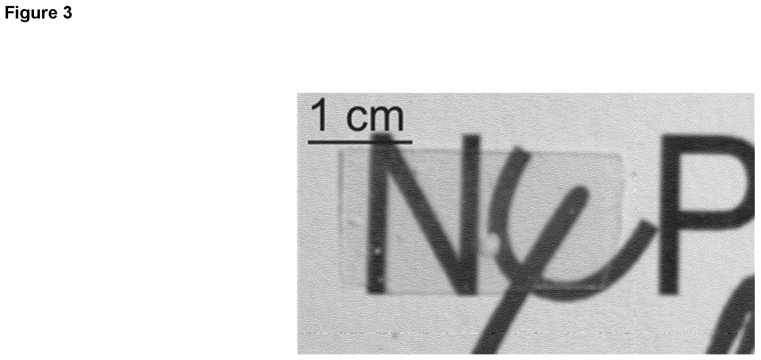

Thermal debinding, sintering and hot isostatic pressing were carried out in the same manner as outlined above in connection with Example 1, thereby obtaining a transparent article made of spinel. The transparent article made of spinel with a thickness of 1.0 mm is shown in **Figure 3****.**

### Example 3 (Reference Example)

Production of a transparent article made of spinel by means of injection molding
A moldable nanocomposite was obtained by dispersing 38 parts per volume of spinel nanopowder having a mean average diameter of 200 nm in 100 parts per volume of a mixture of poly(vinyl butyral) (42.5 parts per volume) as the organic binder, stearic acid (15 parts per volume) as the dispersion agent, and polyethylene glycol (42.5 parts per volume) as the phase-forming agent. For dispersing the spinel nanopowder, the organic binder was heated in advance.

The moldable nanocomposite was injection-molded at 130 °C and 8 bar for 4 seconds using a microinjection molder (DSM X-Plore). The holding pressure was set to 8 bar and the mold temperature was set to 55 °C. Thereby, a green body was obtained.

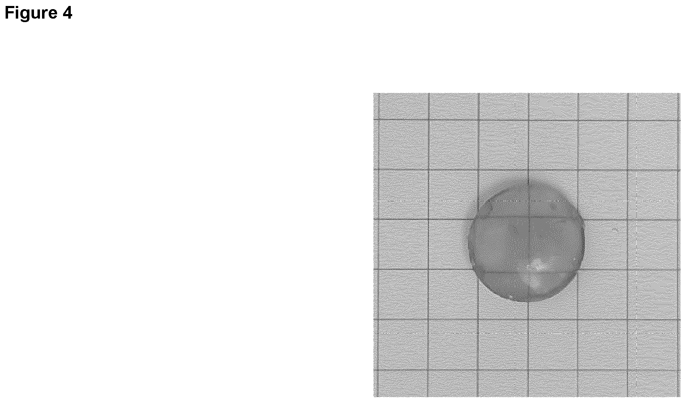

Thermal debinding, sintering and hot isostatic pressing were carried out in the same manner as outlined above in connection with Example 1, thereby obtaining a transparent article made of spinel. The transparent article made of spinel with a thickness of 4.5 mm is shown in **Figure 4****.**

### Comparative Example

Production of an article made of spinel by means of casting without the use of a phase-forming agent
A moldable nanocomposite was obtained by dispersing 38 parts per volume of spinel nanopowder having a mean average diameter of 200 nm in 100 parts per volume of a mixture of 2-hydroxyethyl methacrylate (93 parts per volume) and tetraethylene glycol diacrylate (7 parts per volume) as the organic binder. The spinel nanopowder was dispersed using a cationic polymeric dispersion agent (Hypermer KD1). 2,2-Dimethoxy-2-phenylacetophenone was added as the initiator for facilitating photocuring of the organic binder.

The moldable nanocomposite was cast into a polyethylene mold and the organic binder was hardened upon curing with light having a wavelength in the range from 300 nm to 400 nm, thereby obtaining a green body. The organic binder was removed from the obtained green body by thermal debinding applying the following protocol, thereby obtaining a brown body:

| | | | |
|---|---|---|---|
| • | heating rate: 0.5 °C/minute: | 25 °C → 150 °C | holding time: 4 hours |
| • | heating rate: 0.5 °C/minute: | 150 °C → 280 °C | holding time: 4 hours |
| • | heating rate: 1 °C/minute: | 280 °C → 550 °C | holding time: 2 hours |
| • | cooling rate: 5 °C/minute: | 550 °C → 25 °C | end |

The obtained brown body was sintered to reach a density of about 96% to 100% of the theoretical density applying the following protocol:

| | | | |
|---|---|---|---|
| • | heating rate: 5 °C/minute: | 25 °C → 1530 °C | holding time: 4 hours |
| • | cooling rate: 5 °C/minute: | 1530 °C → 25 °C | end |

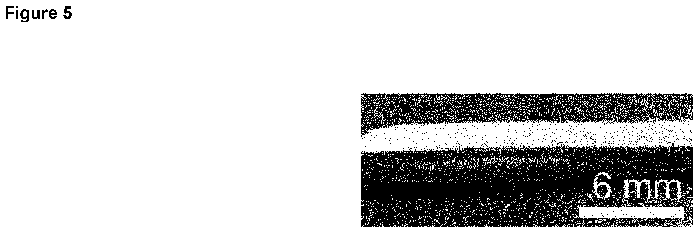

After sintering, an article made of spinel was obtained, which had a polycrystalline morphology. Since no phase-forming agent was present in the moldable nanocomposite, cracking occurred during thermal debinding with the result that the article was broken. The broken article with a thickness of 1.5 mm is shown in **Figure 5****.**

## Claims

1. A moldable nanocomposite for producing a transparent article made of a ceramic material, the moldable nanocomposite comprising:
an organic binder;
a powder of the ceramic material dispersed in the organic binder, the powder comprising particles having a diameter in the range from 5 nm to 700 nm and, in addition thereto, comprising particles having a diameter in the range from 1 µm to 50 µm, and/or a precursor of the ceramic material dispersed in the organic binder, the precursor being at least one metal-containing compound; and
a phase-forming agent dispersed in the organic binder, the phase-forming agent being solid or having a viscosity of at least 5 mPa·s at 25 °C, as measured in accordance with DIN 53019, and forming an internal phase in the organic binder, wherein the combined content of the powder and the precursor of the ceramic material in the moldable nanocomposite is at least 5 parts per volume based on 100 parts per volume of the organic binder,
wherein the content of the phase-forming agent in the moldable nanocomposite is at least 5 parts per volume based on 100 parts per volume of the organic binder, wherein the moldable nanocomposite does not contain any solvent having a viscosity of less than 5 mPa·s at 25 °C, as measured in accordance with DIN 53019, wherein the organic binder is a thermoplastic which can be hardened upon cooling or a resin which can be hardened upon curing or polymerizing initiated by an external stimulus, and
wherein the content of the organic binder with the powder and/or the precursor of the ceramic material dispersed therein, including any initiator added to the organic binder, amounts to at least 70 mass-%, with the total mass of the moldable nanocomposite being 100 mass-%.

2. The moldable nanocomposite according to claim 1, wherein the moldable nanocomposite comprises the precursor of the ceramic material dispersed in the organic binder, the precursor being at least one metal-containing compound selected from the group consisting of organometallic compounds, metal complexes and metal salts, or a combination of two or more thereof.

3. The moldable nanocomposite according to claim 1 or 2, wherein the ceramic material is selected from the group consisting of magnesium aluminate, aluminum oxide, aluminum oxynitride, calcium fluoride, barium titanate, zirconia and yttrium aluminum garnet.

4. The moldable nanocomposite according to any one of claims 1 to 3, wherein the combined content of the powder and the precursor of the ceramic material in the moldable nanocomposite is at least 30 parts per volume based on 100 parts per volume of the organic binder.

5. The moldable nanocomposite according to any one of claims 1 to 4, wherein the content of the phase-forming agent in the moldable nanocomposite is at least 10 parts per volume based on 100 parts per volume of the organic binder.

6. A method of producing a transparent article made of a ceramic material, the method comprising the following steps (a) to (d):
(a) shaping the moldable nanocomposite according to any one of claims 1 to 5 into a predetermined geometric form before, during and/or after hardening of the organic binder, thereby obtaining a primary structure;
(b) debinding the primary structure obtained in step (a) by removing the organic binder, thereby obtaining a secondary structure, the secondary structure having cavities formed therein;
(c) optionally filling the cavities of the secondary structure obtained in step (b) with at least one additive; and
(d) sintering the secondary structure obtained in step (b) optionally filled with at least one additive in step (c), thereby obtaining the transparent article,
wherein the phase-forming agent is removed from the organic binder before or during debinding of the primary structure in step (b).

7. The method according to claim 6, wherein the moldable nanocomposite is shaped in step (a) by means of a subtractive manufacturing process, an additive manufacturing process, a replication process, or a combination thereof.

8. The method according to claim 6 or 7, wherein the primary structure obtained in step (a) is debound in step (b) by means of thermal treatment, chemical reaction, reduced pressure, solvent or gas phase extraction, or a combination thereof.

9. The method according to any one of claims 6 to 8, wherein the cavities of the secondary structure obtained in step (b) are filled with the at least one additive in step (c), the at least one additive being selected from the group consisting of a pigment, a doping reagent, a powder of the ceramic material, and a precursor of the ceramic material.

10. The method according to any one of claims 6 to 9, wherein the cavities of the secondary structure obtained in step (b) are filled with the at least one additive in step (c) by immersing the secondary structure in a solution containing the at least one additive, exposing the secondary structure to physical or chemical vapor deposition in an atmosphere containing or generating the at least one additive, or a combination thereof.

11. The method according to any one of claims 6 to 10, wherein step (d) includes subjecting the sintered secondary structure to hot isostatic pressing.

12. The method according to any one of claims 6 to 11, further comprising the following step (e):
(e) transforming the secondary structure obtained in step (b) or the transparent article obtained in step (d) into a single crystal by exposing either the secondary structure obtained in step (b) or the transparent article obtained in step (d) to an external stimulus,
wherein the transformation is induced via abnormal grain growth with a seed crystal.

## Patentansprüche

1. Formbares Nanokomposit zur Herstellung eines transparenten Artikels aus einem keramischen Material, wobei das formbare Nanokomposit umfasst:
ein organisches Bindemittel;
ein Pulver des keramischen Materials, dispergiert in dem organischen Bindemittel, wobei das Pulver Teilchen mit einem Durchmesser im Bereich von 5 nm bis 700 nm umfasst und zusätzlich hierzu Teilchen mit einem Durchmesser im Bereich von 1 µm bis 50 µm umfasst, und/oder einen Vorläufer des keramischen Materials, dispergiert in dem organischen Bindemittel, wobei der Vorläufer mindestens eine metallhaltige Verbindung ist; und
ein Phasenbildungsmittel, dispergiert in dem organischen Bindemittel, wobei das Phasenbildungsmittel fest ist oder eine Viskosität von mindestens 5 mPa·s bei 25 °C, gemessen in Übereinstimmung mit DIN 53019, aufweist und eine innere Phase in dem organischen Bindemittel ausbildet,
wobei der kombinierte Gehalt des Pulvers und des Vorläufers des keramischen Materials in dem formbaren Nanokomposit mindestens 5 Volumenteile, bezogen auf 100 Volumenteile des organischen Bindemittels, beträgt,
wobei der Gehalt des Phasenbildungsmittels in dem formbaren Nanokomposit mindestens 5 Volumenteile, bezogen auf 100 Volumenteile des organischen Bindemittels, beträgt,
wobei das formbare Nanokomposit kein Lösungsmittel mit einer Viskosität von weniger als 5 mPa·s bei 25 °C, gemessen in Übereinstimmung mit DIN 53019, enthält,
wobei das organische Bindemittel ein Thermoplast, der durch Kühlen gehärtet werden kann, oder ein Harz, das durch Aushärten oder Polymerisieren, initiiert durch einen äußeren Stimulus, gehärtet werden kann, ist, und
wobei der Gehalt des organischen Bindemittels mit dem darin dispergierten Pulver und/oder Vorläufer des keramischen Materials, einschließlich eines zu dem organischen Bindemittel hinzugefügten Initiators, mindestens 70 Masse-% ausmacht, wobei die Gesamtmasse des formbaren Nanokomposits 100 Masse-% beträgt.

2. Formbares Nanokomposit nach Anspruch 1, wobei das formbare Nanokomposit den Vorläufer des keramischen Materials, dispergiert in dem organischen Bindemittel, umfasst, wobei der Vorläufer mindestens eine metallhaltige Verbindung, ausgewählt aus der Gruppe, bestehend aus metallorganischen Verbindungen, Metallkomplexen und Metallsalzen, oder eine Kombination von zwei oder mehreren hiervon ist.

3. Formbares Nanokomposit nach Anspruch 1 oder 2, wobei das keramische Material aus der Gruppe, bestehend aus Magnesiumaluminat, Aluminiumoxid, Aluminiumoxynitrid, Calciumfluorid, Bariumtitanat, Zirkonoxid und Yttrium-Aluminium-Granat, ausgewählt ist.

4. Formbares Nanokomposit nach einem der Ansprüche 1 bis 3, wobei der kombinierte Gehalt des Pulvers und des Vorläufers des keramischen Materials in dem formbaren Nanokomposit mindestens 30 Volumenteile, bezogen auf 100 Volumenteile des organischen Bindemittels, beträgt.

5. Formbares Nanokomposit nach einem der Ansprüche 1 bis 4, wobei der Gehalt des Phasenbildungsmittels in dem formbaren Nanokomposit mindestens 10 Volumenteile, bezogen auf 100 Volumenteile des organischen Bindemittels, beträgt.

6. Verfahren zur Herstellung eines transparenten Artikels aus einem keramischen Material, wobei das Verfahren die folgenden Schritte (a) bis (d) umfasst:
(a) Formen des formbaren Nanokomposits nach einem der Ansprüche 1 bis 5 in eine vorbestimmte geometrische Form vor, während und/oder nach Härten des organischen Bindemittels, wodurch eine Primärstruktur erhalten wird;
(b) Entbindern der Primärstruktur, erhalten in Schritt (a), durch Entfernen des organischen Bindemittels, wodurch eine Sekundärstruktur erhalten wird, wobei die Sekundärstruktur darin ausgebildete Hohlräume aufweist;
(c) gegebenenfalls Befüllen der Hohlräume der Sekundärstruktur, erhalten in Schritt (b), mit mindestens einem Additiv; und
(d) Sintern der Sekundärstruktur, erhalten in Schritt (b), gegebenenfalls befüllt mit mindestens einem Additiv in Schritt (c), wodurch der transparente Artikel erhalten wird,
wobei das Phasenbildungsmittel aus dem organischen Bindemittel vor oder während Entbindern der Primärstruktur in Schritt (b) entfernt wird.

7. Verfahren nach Anspruch 6, wobei das formbare Nanokomposit in Schritt (a) mittels eines subtraktiven Fertigungsprozesses, eines additiven Fertigungsprozesses, eines Replikationsprozesses oder einer Kombination hiervon geformt wird.

8. Verfahren nach Anspruch 6 oder 7, wobei die Primärstruktur, erhalten in Schritt (a), in Schritt (b) mittels thermischer Behandlung, chemischer Reaktion, reduziertem Druck, Lösungsmittel- oder Gasphasenextraktion oder einer Kombination hiervon entbindert wird.

9. Verfahren nach einem der Ansprüche 6 bis 8, wobei die Hohlräume der Sekundärstruktur, erhalten in Schritt (b), mit dem mindestens einen Additiv in Schritt (c) befüllt werden, wobei das mindestens eine Additiv aus der Gruppe, bestehend aus einem Pigment, einem Dotierreagenz, einem Pulver des keramischen Materials und einem Vorläufer des keramischen Materials, ausgewählt ist.

10. Verfahren nach einem der Ansprüche 6 bis 9, wobei die Hohlräume der Sekundärstruktur, erhalten in Schritt (b), mit dem mindestens einen Additiv in Schritt (c) durch Eintauchen der Sekundärstruktur in eine Lösung, enthaltend das mindestens eine Additiv, Aussetzen der Sekundärstruktur physikalischer oder chemischer Gasphasenabscheidung in einer Atmosphäre, enthaltend oder erzeugend das mindestens eine Additiv, oder eine Kombination hiervon befüllt werden.

11. Verfahren nach einem der Ansprüche 6 bis 10, wobei Schritt (d) Unterziehen der gesinterten Sekundärstruktur einem heißisostatischen Pressen einschließt.

12. Verfahren nach einem der Ansprüche 6 bis 11, weiter umfassend den folgenden Schritt (e):
(e) Umwandeln der Sekundärstruktur, erhalten in Schritt (b), oder des transparenten Artikels, erhalten in Schritt (d), in einen Einkristall, indem entweder die Sekundärstruktur, erhalten in Schritt (b), oder der transparente Artikel, erhalten in Schritt (d), einem äußeren Stimulus ausgesetzt wird,
wobei die Umwandlung durch abnormales Kornwachstum mit einem Impfkristall induziert wird.

## Revendications

1. Nanocomposite moulable destiné à produire un article transparent réalisé en un matériau céramique, le nanocomposite moulable comprenant :
un liant organique ;
une poudre du matériau céramique dispersée dans le liant organique, la poudre comprenant des particules ayant un diamètre dans la plage allant de 5 nm à 700 nm et, outre celles-ci, comprenant des particules ayant un diamètre dans la plage allant de 1 µm à 50 µm, et/ou un précurseur du matériau céramique dispersé dans le liant organique, le précurseur étant au moins un composé contenant du métal ; et
un agent de formation de phase dispersé dans le liant organique, l'agent de formation de phase étant solide ou ayant une viscosité d'au moins 5 mPa·s à 25 °C, telle que mesurée conformément à DIN 53019, et formant une phase interne dans le liant organique, dans lequel la teneur combinée en la poudre et le précurseur du matériau céramique dans le nanocomposite moulable est d'au moins 5 parties en volume basée sur 100 parties en volume du liant organique,
dans lequel la teneur en l'agent de formation de phase dans le nanocomposite moulable est d'au moins 5 parties en volume basée sur 100 parties en volume du liant organique, dans lequel le nanocomposite moulable ne contient pas de solvant ayant une viscosité de moins de 5 mPa·s à 25 °C, telle que mesurée conformément à DIN 53019, dans lequel le liant organique est un thermoplastique qui peut être durci dès refroidissement ou une résine qui peut être durcie dès cuisson ou polymérisation initiée par un stimulus externe, et
dans lequel la teneur en le liant organique avec la poudre et/ou le précurseur du matériau céramique dispersé(e) en son sein, incluant tout initiateur ajouté au liant organique, représente au moins 70 % en masse, avec la masse totale du nanocomposite moulable qui est de 100 % en masse.

2. Nanocomposite moulable selon la revendication 1, dans lequel le nanocomposite moulable comprend le précurseur du matériau céramique dispersé dans le liant organique, le précurseur étant au moins un composé contenant du métal sélectionné parmi le groupe constitué de composés organométalliques, de complexes métalliques et de sels métalliques, ou une combinaison de deux ou plus de ceux-ci.

3. Nanocomposite moulable selon la revendication 1 ou 2, dans lequel le matériau céramique est sélectionné parmi le groupe constitué de l'aluminate de magnésium, de l'oxyde d'aluminium, de l'oxynitrure d'aluminium, du fluorure de calcium, du titanate de baryum, du dioxyde de zirconium et d'un grenat d'yttrium et d'aluminium.

4. Nanocomposite moulable selon l'une quelconque des revendications 1 à 3, dans lequel la teneur combinée en la poudre et le précurseur du matériau céramique dans le nanocomposite moulable est d'au moins 30 parties en volume basée sur 100 parties en volume du liant organique.

5. Nanocomposite moulable selon l'une quelconque des revendications 1 à 4, dans lequel la teneur en l'agent de formation de phase dans le nanocomposite moulable est d'au moins 10 parties en volume basée sur 100 parties en volume du liant organique.

6. Procédé de production d'un article transparent réalisé en un matériau céramique, le procédé comprenant les étapes (a) à (d) suivantes :
(a) mettre en forme le nanocomposite moulable selon l'une quelconque des revendications 1 à 5 en une forme géométrique prédéterminée avant, au cours du et/ou après durcissement du liant organique, obtenant de ce fait une structure primaire ;
(b) délier la structure primaire obtenue à l'étape (a) en éliminant le liant organique, obtenant de ce fait une structure secondaire, la structure secondaire ayant des cavités formées en son sein ;
(c) remplir en option les cavités de la structure secondaire obtenue à l'étape (b) d'au moins un additif ; et
(d) fritter la structure secondaire obtenue à l'étape (b) remplie en option d'au moins un additif à l'étape (c), obtenant de ce fait l'article transparent,
dans lequel l'agent de formation de phase est éliminé du liant organique avant ou au cours du déliage de la structure primaire à l'étape (b).

7. Procédé selon la revendication 6, dans lequel le nanocomposite moulable est mis en forme à l'étape (a) au moyen d'un processus de fabrication soustractive, d'un processus de fabrication additive, d'un processus de réplication ou d'une combinaison de ceux-ci.

8. Procédé selon la revendication 6 ou 7, dans lequel la structure primaire obtenue à l'étape (a) est déliée à l'étape (b) au moyen d'un traitement thermique, d'une réaction chimique, d'une pression réduite, d'un solvant ou d'une extraction en phase gazeuse ou d'une combinaison de ceux-ci.

9. Procédé selon l'une quelconque des revendications 6 à 8, dans lequel les cavités de la structure secondaire obtenue à l'étape (b) sont remplies de l'au moins un additif à l'étape (c), l'au moins un additif étant sélectionné parmi le groupe constitué d'un pigment, d'un réactif de dopage, d'une poudre du matériau céramique et d'un précurseur du matériau céramique.

10. Procédé selon l'une quelconque des revendications 6 à 9, dans lequel les cavités de la structure secondaire obtenue à l'étape (b) sont remplies de l'au moins un additif à l'étape (c) en immergeant la structure secondaire dans une solution contenant l'au moins un additif, exposant la structure secondaire à un dépôt en phase vapeur physique ou chimique dans une atmosphère contenant ou générant l'au moins un additif ou une combinaison de ceux-ci.

11. Procédé selon l'une quelconque des revendications 6 à 10, dans lequel l'étape (d) inclut soumettre la structure secondaire frittée à un pressage isostatique à chaud.

12. Procédé selon l'une quelconque des revendications 6 à 11, comprenant en outre l'étape (e) suivante :
(e) transformer la structure secondaire obtenue à l'étape (b) ou l'article transparent obtenu à l'étape (d) en un cristal unique en exposant soit la structure secondaire obtenue à l'étape (b), soit l'article transparent obtenu à l'étape (d) à un stimulus externe,
dans lequel la transformation est induite par le biais d'une croissance de grain anormale avec un germe cristallin.
